Europäisches Patentamt

European Patent Office

Office européen des brevets

(19)

(11) **EP 0 753 201 B1**

(12) **EUROPEAN PATENT SPECIFICATION**

(45) Date of publication and mention
of the grant of the patent:
**26.05.1999 Bulletin 1999/21**

(21) Application number: **95903649.2**

(22) Date of filing: **28.11.1994**

(51) Int Cl.$^6$: **H01J 37/34**

(86) International application number:
**PCT/US94/13759**

(87) International publication number:
**WO 95/26566 (05.10.1995 Gazette 1995/42)**

(54) **A SPUTTER METHOD AND A SPUTTERING TARGET**

ZERSTÄUBUNGSVERFAHREN UND EIN ZERSTÄUBUNGSTARGET

PROCEDE DE PULVERISATION ET CIBLE DE PULVERISATION

(84) Designated Contracting States:
**BE CH DE FR GB IT LI LU NL SE**

(30) Priority: **28.03.1994 US 218731**

(43) Date of publication of application:
**15.01.1997 Bulletin 1997/03**

(73) Proprietor: **Tokyo Electron Limited
Minato-ku, Tokyo 107 (JP)**

(72) Inventors:
• **HURWITT, Steven
Park Ridge, NJ 07656 (US)**

• **WAGNER, Israel
Monsey, NY 10952 (US)**

(74) Representative: **Cotter, Ivan John et al
D. YOUNG & CO.
21 New Fetter Lane
London EC4A 1DA (GB)**

(56) References cited:
**EP-A- 0 313 750          EP-A- 0 365 249
EP-A- 0 440 377          US-A- 4 724 060
US-A- 5 130 005**

## Description

The present invention relates to sputter deposition, and particularly to the design and use of sputter coating cathode assemblies, particularly magnetron sputtering cathode assemblies, for use in collimated deposition.

## Background of the Invention:

In sputter deposition processes, a great deal of attention has been historically paid to the thickness uniformity of the deposited film. In many commercial scale processes for applying sputter coated films to the surfaces of semiconductor wafers, particularly these in which a high rate of deposition is also a consideration, magnetron enhanced plasma generation and plasma shaping are employed to establish an erosion profile of the sputtering target that assists in providing the desired distribution of target material consumed on the target surface and desired distribution of film deposited on the wafer substrate.

More recently, users of sputter coating equipment for the production of semiconductor wafers have deemed it desirable to use, and manufacturers of such equipment has deemed it desirable to provide, sputter coating target and cathode assemblies in which rotating magnet packages are used to provide the magnetron enhancement of the ion producing plasma for use in the sputter coating process for removal of the sputter coating material from the target. One such rotating magnet sputtering target and cathode assembly is described and illustrated in U.S. Patent No. 5,130,005 entitled MAGNETRON SPUTTER COATING METHOD AND APPARATUS WITH ROTATING MAGNET CATHODE.

In the design of sputtering cathode assemblies, it has been recognized that the uniformity of the film deposited on the surface of a substrate is improved by making the target large with respect to the surface of the substrate being coated. Theoretically, with all other parameters being equal, an infinitely large target with a uniform erosion profile is capable of overcoming coating non-uniformity that is due to the presence of less of the sputtering source near the edge of the substrate than there is near the substrate center. There are, however, practical limitations on the sizes of sputtering targets. Usually, a compromise is made by coating circular wafer substrates by providing a target that has a diameter about one-third or one-half larger than that of the wafer being coated. Nonetheless, with this compromise, a uniformly eroded target will result in the deposition of a coating that is progressively thicker moving from the rim of the substrate toward the center.

In the manufacture of cathode assemblies, the designs have been optimized to shape the erosion profiles of the targets to compensate for the thinner edge coating effect and other factors contributing to lack of uniformity of the sputtered film being deposited. This design optimization is commonly carried out by selectively configuring the magnet assemblies used to shape the plasma. To overcome the thinness of the coating at the edge, magnet assemblies are often designed to produce a stronger magnetic field to trap more plasma around the edge of the target, which causes the target to erode at a higher rate near the edge to compensate for the lesser target area near the rim of the substrate.

An additional consideration arises when the wafers being coated are not flat smooth surfaces on which the film is to be deposited, but are stepped, having micron size vias with walls perpendicular to the surface of the wafer. In certain applications, it is sought to apply the sputtered coatings on the bottoms of the vias, which are shadowed by the vias' stepped sides. In such applications, it becomes a goal to apply the coating of a sufficient thickness on the bottoms of the vias before excessive coating is deposited on the vias stepped sides. In some applications, this goal is pursued by providing a collimator between the target and the semiconductor wafer to restrict the amount of shallow angle particles impinging on the wafer from the target. By providing a collimator, the angle of incidence of sputtered material moving from the target toward the substrate is restricted to angles nearly perpendicular to the target, whereby the deposition rate on the sides of the vias is reduced, while the rate of coating material deposited on the via bottoms by particles moving perpendicular to the target and wafer is not materially retarded.

European Patent Application 0440377 describes a sputtering apparatus in which a collimator is provided between the target and the substrate to be coated. The collimator cells have a length to diameter ratio of 1:1 to 3:1. The target has a greater lateral extent than the substrate. The particles are said to be emitted from the target in substantially uniform manner.

With the use of a collimator between the target and the substrate being sputter coated, size of the target in relation to the wafer has a different effect than it does with sputtering arrangements in which collimators are not being used. As a consequence, a sputtering cathode design, optimized to produce uniformity in a non-collimated application, no longer performs optimally with the collimator. As a result, the bottoms of vias on some parts of the wafer become coated at different rates, and to different film thickness, than those at other parts of the wafer. It has been found by applicants that an ideal cathode assembly for use in a non-collimated application tends to result in excessive deposition near the edge of the wafer substrates and insufficient deposition remote from the edge and nearer the center of the wafer.

In attempting to improve sputter coating uniformity in collimated sputter coating applications, some have embarked on a trial and error modification of sputtering cathode assemblies. While some such attempts have produced an improved result with a particular collimator being used, the improvements tend to be lost when the design of the collimator is changed. In fact, it has been found that over the life of a collimator or over the life of a sputtering target, the improved effects of such haphazard approach to cathode assembly design has been found to dissipate.

One cause of film uniformity changes over the life of a collimator or target has been found by applicants to be the collimator design parameter referred to as the aspect ratio. A collimator is usually regarded as a grid like structure interposed between the target and the substrate having an array of holes therethrough for the passage of particles. The holes in the collimators have some size or dimension such as a hole diameter, where the holes are round, or an equivalent dimension where the holes are otherwise shaped, such as hexagonal or square. The collimator also has a thickness, which is the dimension through the hole in a direction normal to the target and substrate along which a particle must pass to move from the target to the wafer surface. An aspect ratio of a collimator is usually defined as the ratio of the collimator thickness to the effective diameter of the collimator holes. The higher the aspect ratio, the greater the collimating effect that is produced by the collimator in restricting the particles to those that are generally moving from the target to the substrate in a direction normal to the collimator, and hence to the surface of the substrate, which is typically parallel to the collimator.

The change in aspect ratio over the life of the collimator, referred to above, has been found to occur at least in part because the wide angle particles that do not pass through the collimator holes are rather blocked by the web or grid structure that forms the side walls of the collimator holes, tends to coat the sides of the holes of the collimator, causing the holes to narrow. Thus, cathode assemblies that are optimized to produce an erosion profile that results in acceptable film uniformity deposited by a collimated source having a particular aspect ratio have been found by applicants to cease to be optimized as the collimator is used.

Furthermore, the greater the film thicknesses being deposited, the greater is the rate at which the collimators become coated to the point that they are no longer suitable for their applications. Cathode assembly designs that work for only a specific or narrow range of collimator aspect ratios are less useful for depositing materials to great thicknesses, and thus have been limited to use with only very thin films such as barrier layers of, for example, titanium or titanium nitride.

There is a need for a sputtering cathode design, particularly a systematic criteria use in configuring the magnetron and other plasma shaping assemblies of a sputtering cathode design, so that uniformity in the film applied using collimated sputtering sources, particularly having collimators of a range of contemplated collimator designs, is maintained. There is further a need to overcome the above described problems to extend the utility of collimated sputter coating to more materials, and to otherwise render collimated sputter deposition more efficient and more effective.

### Summary of the Invention:

An objective of the present invention is to provide a cathode assembly that produces an erosion profile for a sputtering target which, if used with a collimator, provides uniform film deposition.

It is a further objective of the present invention to provide a cathode assembly for a sputter coating apparatus that will provide uniform film deposition when used with a collimator having an aspect ratio that falls within a wide range.

More particular objectives of the present invention are to provide a cathode assembly design that is effective to provide uniform collimated deposition as the aspect ratio of the collimator varies over the course of its use.

A sputtering method in accordance with the invention comprises the steps of providing a wafer support for holding a circular wafer centered on an axis, providing a sputtering target formed of sputtering material, having a circular outer rim centered on the axis, and having a sputtering surface spaced from, parallel to and facing the support, providing a collimator centered on the axis spaced from, between and parallel to the target and the support, and having an aspect ratio of at least 0.5, the aspect ratio being the ratio of the thickness (T) of the collimator to the width of the cells of the collimator, shaping with magnet assembly means positioned behind the target a plasma adjacent the sputtering surface of the target characterised in that the plasma is shaped such as to produce an erosion profile on the sputtering surface of the target that includes an annular peripheral area of maximum erosion adjacent the rim of the target and an interior area radially inward of the peripheral area of generally uniform erosion that is less than the maximum erosion and greater than half of the maximum erosion.

A sputtering cathode assembly in accordance with the invention comprises a wafer support for holding a circular wafer centered on an axis, a sputtering target formed of sputtering material, having a circular outer rim centered on the axis, and a sputtering surface spaced from, parallel to and facing the support, a collimator centered on the axis spaced from, between and parallel to the target and the support, and having an aspect ratio of at least 0.5, the aspect ratio being the ratio of the thickness of the collimator to the width of the cells of the collimator and magnet assembly means positioned behind the target and configured for shaping a plasma adjacent the sputtering surface of the target characterised in that the magnet assembly is configured for shaping the plasma to produce therewith an erosion profile on the sputtering surface of the target that includes an annular peripheral area of maximum erosion adjacent the rim of the target and an interior area radially inward of the peripheral area of generally uniform erosion that is less than the maximum erosion and greater than half of the maximum erosion.

In accordance with the principles of the present invention, there is provided a method of and apparatus for eroding a sputtering target so as to form an erosion groove profile which is substantially uniform in an interior area of the target with a deeper, preferably asymmetrically gaussian shaped, enhancement near the outer edge of the target. In accordance with a preferred embodiment of the invention, the erosion profile provided by the method and apparatus of the invention has a relatively deep enhancement area near the outer edge of the target, a specified and shallower erosion area near the center of the target, and an intermediate annular area that is flat to a prescribed degree between the center and the edge areas.

Further in accordance with the present invention, a cathode assembly as set forth above is provided, in a sputter coating apparatus, in combination with a collimator of aspect ratios of greater than approximately 0.5, and in the preferred combination, with aspect ratios of at least approximately 1.0, and preferably in the range of from 1.0 to at least 2.0.

Further in accordance with the preferred embodiment of the present invention, the cathode assembly includes a rotating magnet assembly, which in conjunction with a sputtering target, forms an erosion groove profile as described above.

The method and apparatus of the present invention provide uniform film deposition when used with collimators over a wide range of aspect ratios.

The present invention provides the advantages of improving the film thickness uniformity achievable with a collimator by modifying the shape of the erosion profile produced in the sputtering target. In addition, the invention provides a range of target erosion profiles, including specific profiles, which will perform with a range of collimator aspect ratios. Further, the invention provides a target erosion profile which will perform in a more consistent manner as the targets erode deeply and the distance from substrate to sputter surface changes.

These and other objectives and advantages of the present invention will be more readily apparent from the following detailed description in which:

## Brief Description of the Drawings:

**Fig. 1** is a diagram illustrating a typical non-collimated sputtering target and wafer arrangement.

**Fig. 2** is a diagram illustrating the sputtering target of **Fig. 1** in combination with a collimator of relatively low aspect ratio.

**Fig. 3** is a diagram similar to **Fig. 2** but illustrating a collimator of higher aspect ratio.

**Fig. 4** is a diagram similar to **Fig. 3** but illustrating a collimator of still higher aspect ratio.

**Fig. 5** is a graph representing an equation describing a target erosion profile for use without a collimator.

**Fig. 6** is a graph similar to **Fig. 5**, but representing an equation describing a target erosion profile for use with a collimator having an aspect ratio lying within an extended range.

**Fig. 7** is a graph illustrating uniformity measurements made after introducing collimators into sputtering devices employing cathode assemblies producing the erosion profile of **Fig 5**.

**Fig. 8** is a graph, similar to **Fig. 7**, plotting uniformity measurements made with a target in accordance with the erosion profile of **Fig 6**.

## Detailed Description of the Preferred Embodiments:

In the sputter deposition of a thin film of uniform thickness across a substrate, there is a known geometrical relationship between the degree of uniformity, the substrate size, the spacing between target and substrate, and the specific shape and size of the erosion profile in the target. However, it has been found that, when a collimating structure is interposed between the target and substrate, which is frequently done in order to improve the coating of three dimensional features on the substrate surface, and particularly to improve the sidewall and bottom step coverage of sub-micron features, the resulting uniformity is significantly changed. Additionally, as the aspect ratio of the collimator changes over the course of the use of the collimator, or by operator selection to satisfy application requirements, film thickness uniformity changes. As such, the best uniformity achieved is generally not as good as the uniformity possible without a collimator when the target erosion profile was developed for non-collimator performance.

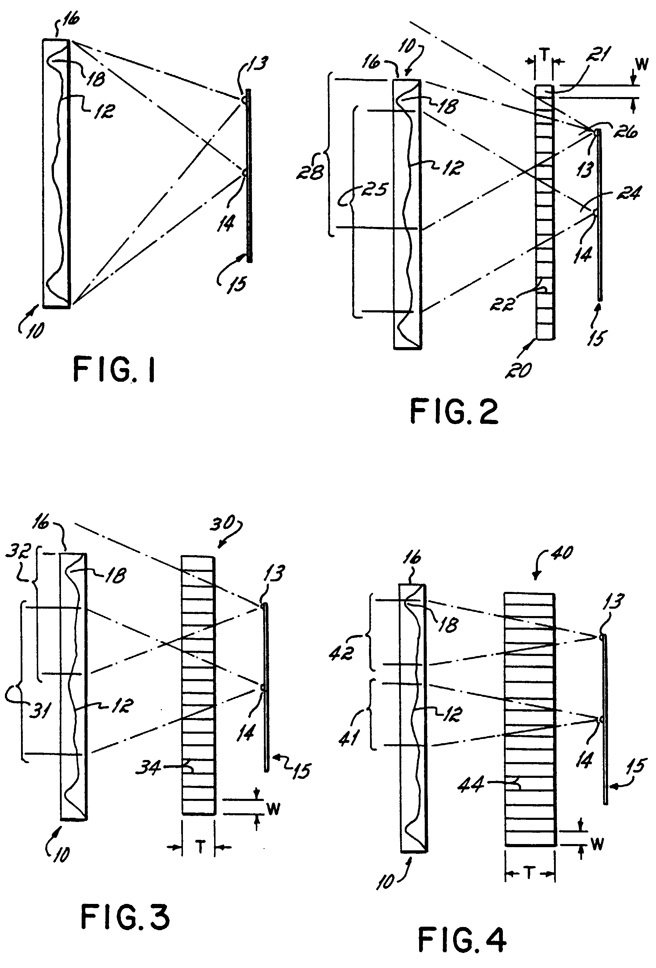

The reason for this effect is illustrated in **Figs. 1-3**. **Fig. 1** diagrammatically illustrates a cross section through the center of a circular target 10. Plotted on the target 10 is an erosion profile 12 representing the relative rates at which material is sputtered from various points across the diameter of the target 10. The profile 12 illustrated is representative of the profile produced when the cathode is designed according to parameters established for use of the target 10 without a collimator. Typical points 13 and 14 on substrate 15 both "see" the entire target area without restriction. Points such as point 13 near the edge or rim 16 of the target 10 see less target than points such as point 14 more central on the target 10, and thus will receive less sputtered material unless the areas of the target 10 closer to it are sputtered at a greater rate. Profile 12, to produce the same film thickness at all points on the surface of the substrate 15, is designed to have a deeper erosion groove 18 near the target edge 16. Such a design is an attempt to approximate a theoretically perfect uniformity that would result from a target of theoretically infinite diameter sputtered to a uniform profile.

**Fig. 2** diagrammatically illustrates the effect of a collimator 20 with a low aspect ratio of about 1. The aspect ratio is defined as the ratio of the thickness *T* to the width *W* of a collimator cell 21. With such a collimator 20, the view from the points on the substrate 15, such as point 14 for example, are limited by the sidewalls 22 of the cells 21 to a maximum angle 24 through which the collimator sees a corresponding area 25 of the target 10. Point 13, which is at the edge of the wafer 13, sees the target 10 through an angle 26, equal to the angle 24. However, because the target 10 only partially fills the field of view spanned by the angle 26, the point 13 sees a smaller area 28 of the target 10 than the area 24 seen by point 14. Because the collimator sidewalls 22 shadow part of the target 10 from the points 13 and 14, each points receives less coating material in a given amount of time than the same points would receive in the non-collimated case of **Fig. 1**. With the profile 12, the collimator affects the points 13 and 14 differently. For example, the deposition rate may be reduced more at point 13 than at point 14, resulting in a difference in uniformity of the deposited film between points 13 and 14 on the substrate 15.

**Fig. 3** diagrammatically illustrates the effect of another collimator 30 having a relatively high aspect ratio of about 3. The areas seen by points 13 and 14 on the wafer 15, for example areas 31 and 32, respectively, become more restricted by sidewalls 34 of the collimator 30, and thus are smaller than the areas 25 and 28 of **Fig. 2**. With the same erosion profile 12, the result of the collimator 30 will be an even greater difference in the film coating uniformity between points 13 and 14 than resulted from the collimator 20 of **Fig. 2**.

**Fig. 4** diagrammatically illustrates the effect of another collimator 40 having an even higher aspect ratio of about 4. The areas seen by points 13 and 14 on the wafer 15, for example areas 41 and 42, respectively, are even more restricted by sidewalls 44 of the collimator 40 than the areas 31 and 32 of **Fig. 3**. With the same erosion profile 12, the result of the collimator 40 will be an even greater difference in the film coating uniformity between points 13 and 14 than resulted from the collimators 20 of **Fig. 2** and 30 of **Fig. 3**. With the collimator 40, however, both of the areas 41 and 42 lie entirely on the surface of the target 10, and thus, the deep erosion groove 18 is counterproductive, as will be seen from the discussion below.

In cases of collimated sputter deposition, ideal uniformity is theoretically achieved with a uniformly eroded target of a radius that is the radius of the substrate plus *Wd/t,* where *d* is the target-to-substrate distance. *W/t* is the collimator hole width-to-thickness ratio, which is the reciprocal of the collimator aspect ratio. For non-collimated sputter deposition, ideal thickness uniformity is achieved with a uniformly eroded target of infinite diameter. With realistic targets of limited actual size, it becomes necessary to modify the erosion to produce non-uniform depths which compensate for the limited size of the target. This follows the general form of deeper erosion, illustrated by the groove 18 in **Figs. 1-4**, near the edge of the target 10, but with significant differences of shape between erosion grooves optimized for use with and without collimators.

A simplified definition of such a shape is provided by the equation:

Equation (1):

$$y(x) = a_0 + I_0 \, e^{-(\frac{x-x_0}{\sigma})^2}$$

$$\text{for } x \leq x_0$$

and

$$y(x) = e^{-(\frac{x-x_0}{\sigma})^2}$$

$$\text{for } x > x_0$$

Where:

*y* = Erosion intensity;
*x* = Distance from target center;
*x₀* = Radius to peak depth of erosion groove;

$a_0$ = Minimum Erosion Intensity for $x \leq x_0$ ;
$I_0$ = Amplitude of enhanced erosion groove from $a_0$ ;
σ = Half width of enhanced erosion groove.

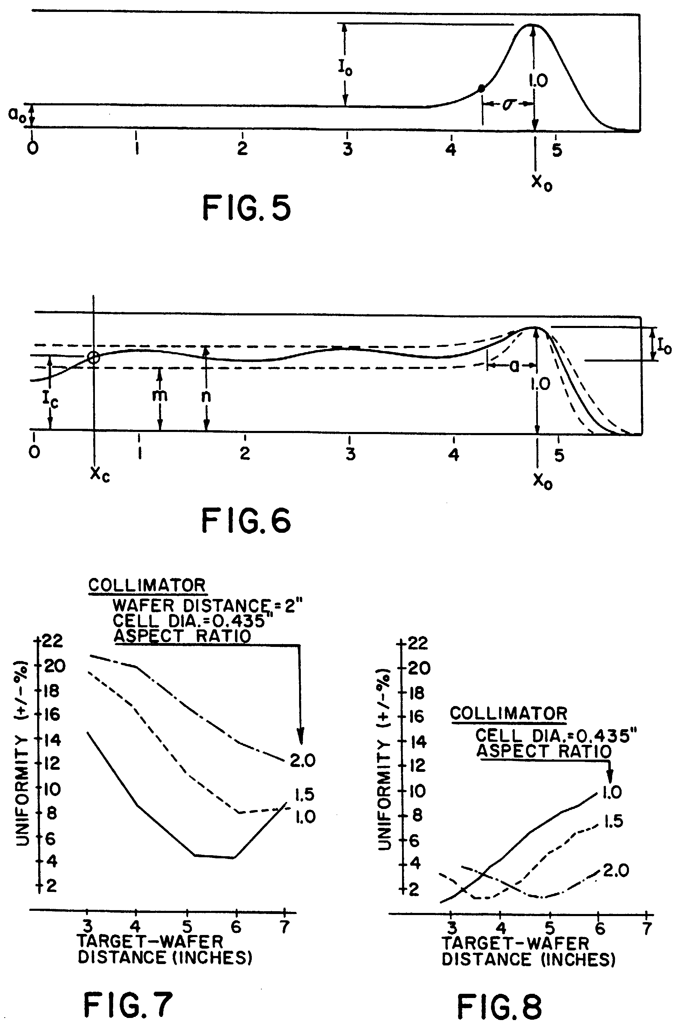

Equation (1) is illustrated in **Fig. 5**, which plots the resultant shape as a level, uniform erosion in the central area of the target, enhanced by a gaussian shaped deeper zone or erosion groove near the edge. For non-collimated sputtering sources, with targets that are about one-third to one-half larger in diameter than the wafers being coated, $a_0$ is typically about 20% of $I_0$.

Because of variables in such things as the characteristics of target materials, gas scattering of sputtered particles, sticking coefficients of sputtered particles and the actual magnet construction and other parameters producing the target erosion, the more fully descriptive equation creates an envelope of erosion shape which permits fine turning for the variables. **Fig. 6** illustrates the envelope developed from the use of Equation (2).

### Equation (2):

$$y(x) = I_c e^{-\left(\frac{x-x_c}{\sigma_c}\right)^2}$$

$$\text{for } x \leq x_c ;$$

$$y(x) = m + \sum_{i=0}^{k} I_i \, e^{-\left(\frac{x-x_i}{\sigma_1}\right)^2} + I_0 \, e^{-\left(\frac{x-x_0}{\sigma_1}\right)^2}$$

$$\text{for } x_c \leq x \leq x_0 ;$$

$$y(x) = e^{-\left(\frac{x-x_0}{\sigma_2}\right)^2}$$

$$\text{for } x \geq x_0 .$$

Where :

$m$ = Minimum erosion intensity on flat part, i.e., for $x_c \leq x \leq x_0$, and
$m + I_0$ = **1.0.** Also:

$$\sum_{i=0}^{k} I_i \, e^{-\left(\frac{x-x_i}{\sigma_1}\right)^2} = \text{Intensity fluctuation on flat part.}$$

where:

$I_i$ = Fluctuation peaks < **(n-m)** ;
$x_0$ = Radius to edge erosion groove;

$$x_i < x_0 ;$$

$\sigma_i$ = Half width of peak *i*.

$$I_0 e^{-(\frac{x-x_0}{\sigma_1})^2} = \text{Edge intensity enhancement for } x \leq x_0 \text{ ;}$$

where:

$\sigma_1 = $ Half width of peak erosion on the inside of the edge erosion groove.

$$e^{-(\frac{x-x_0}{\sigma_2})^2} = \text{Edge intensity for } x > x_0 \text{,}$$

$$\rightarrow 0 \text{ as } x \rightarrow \infty \text{ ;}$$

where:

$\sigma_2 = $ Half width of peak erosion on the outside of the edge erosion groove.

$$I_c e^{-(\frac{x-x_c}{\sigma_c})^2} = \text{Erosion intensity at target center area ;}$$

where:

$$m \leq I_c \leq n \text{ ,}$$

$I_c = $ Max. intensity of center area,

$x_c = $ radius of center area.

In the above equations, the units of measure and constants, such as the "half widths" $\sigma$, are somewhat arbitrary and will be selected based on factors such as magnet structure in the course of the optimization procedure explained below. Based on the selections and adjustments of parameters, the optimization is carried out to derive an envelope, represented by the values *m* and *n,* which define the relative erosion depth of the internal flat portion to the depth of the peripheral groove, and the maximum fluctuation of the erosion peaks within this portion.

**Fig. 7** plots the performance of a standard erosion groove designed for producing +/- 5% uniformity without a collimator when used with collimators of various aspect ratios, while **Fig. 8** plots the improvement of this invention using an erosion profile in accordance with Equation (2).

In accordance with the present invention, when a target is to be used with a collimator, a computer model is constructed representing the geometry of the target, wafer and collimator, in a manner similar to the diagrams of **Figs. 1-4**, described above. Assuming, for example, a circular target, a circular collimator and a circular wafer all centered on the same axis, and given a target diameter, a wafer diameter, a collimator aspect ratio, a target to wafer spacing, and a wafer to collimator spacing, a computer iteration is performed, using any one of a number of suitable numerical methods, to determine the amount of target area that each point on the wafer "sees". The resulting calculation represents the distribution of coating on the wafer that would result if a uniform target erosion profile were employed.

Then, in accordance with the method of the present invention, an erosion profile represented by Equation (2) is introduced. With each point on the surface of the target weighted by the value *y(x)* that results by solving the equation of Equation (2) for a point of radius *x* from the target center or axis, a numerical iteration is performed to minimize the maximum differences among the target areas, weighted by the erosion profile of Equation (2), seen from the points on the wafer surface.

Equation (2), as used in the method as described above, is a tool for use in arriving at the parameters needed for the design of a cathode assembly that will produce the desired erosion profile. The equation is particularly suitable for design of circular magnet designs, particularly rotating magnet assembly that rotates on an axis that aligns with the axis of the target-collimator-wafer assembly. Calculation of the optimized erosion profile produces the parameters $m$, $n$, and $I_i$, including $I_c$. These parameters, for example, may be used to adjust the strengths of magnets in the magnet assembly. The selection of the radii $x_0$, $x_i$ and $x_c$ of the peaks may be selected based on achievable magnet assembly geometry, and may be also varied in the optimization process. In addition, the parameters $\sigma_1$, $\sigma_2$ and $\sigma_c$ are preferably also optimized in the calculation process. These parameters affect both the geometry and strengths of the magnets of the magnet assembly.

Applying the above method, the following sets forth examples of erosion profile parameters that have been derived following Equation (2), in which the relative erosion intensity $y$, as a function of the distance $x$ from the target center or axis:

_Example:_

For a wafer of diameter $D_W$ = 20.3 cm (8 inches), the target will typically have a diameter $D_I = (1.2\ to\ 1.5)\ x$ $D_W$, for example, in the range of 29.2 cm (11.5 inches). The target to wafer spacing with such wafer and target dimensions will be preferably of 7.6 cm (3") to approximately 10.2 cm - 11.4 cm (4.0" - 4.5") (i.e., 3/8 - 1/2, or 3/8 to 9/16 $D_W$). Further, the wafer to collimator spacing in such a configuration will be from approximately 3.18 cm to 4.45 cm (1.25" to 1.75") (approximately 3/16 $D_W$). Then, for collimator aspect ratios of from approximately 1.0 to 2.0, the parameters for designing a magnet assembly or for otherwise controlling the erosion profile of the target are:

$$m = 0.6$$

$$n = 0.75$$

$$I_i < (n-m = 0.15)$$

$$\sigma_1 \le 0.45"; \sigma_2 \le 0.25" ; \sigma_c \le 0.25"$$

$$x_c < 0.25"$$

In the above example, the area of the target inward of the peripheral groove at $x_0$ is eroded to about half or more of the maximum depth of the peripheral groove, and preferably to between 60% and 75% of the depth of the peripheral groove. The ratios may be smaller with collimators of lower aspect ratios and greater with collimators of higher aspect ratios, but significantly greater than the ratio of about 20% that is characteristic of the shallower central erosion employed with non-collimated sources.

In the example, the above listed values of the parameters will provide generally uniform deposition of +/- 5% on the wafer with collimators of aspect ratios ranging from less than 1.0 to more than 2.0. The uniformity with such collimators will be provided where the target, wafer and collimator dimensions and spacings vary somewhat from those used in the example.

The above calculated erosion profiles have been implemented in, and are particularly suitable with, magnet assemblies such as disclosed in U.S. Patent No. 5,130,005 entitled MAGNETRON SPUTTER COATING METHOD AND APPARATUS WITH ROTATING MAGNET CATHODE.

The method set forth above provides erosion profiles that are useful in combination with collimators having aspect ratios of from 0.05 to 5.0. The cathode assembly design set forth above is particularly suitable for collimator aspect ratios of about 1.0 that may vary to up to approximately 2.0. The profiles of such cathode assemblies are particularly capable of replication with rotating magnet assemblies, which in conjunction with a sputtering target, form erosion groove profiles so derived.

## Claims

1. A sputter method comprising the steps of providing a wafer support for holding a circular wafer (15) centered on an axis, providing a sputtering target (10) formed of sputtering material, having a circular outer rim centered on the axis, and having a sputtering surface spaced from, parallel to and facing the support, providing a collimator (20,30,40) centered on the axis spaced from, between and parallel to the target (10) and the support, and having an aspect ratio of at least 0.5, the aspect ratio being the ratio of the thickness (T) of the collimator (20,30,40) to the width of the cells (21) of the collimator, shaping with magnet assembly means positioned behind the target (10) a plasma adjacent the sputtering surface of the target (10) characterised in that the plasma is shaped such as to produce an erosion profile on the sputtering surface of the target (10) that includes an annular peripheral area of maximum erosion adjacent the rim of the target (10) and an interior area radially inward of the peripheral area of generally uniform erosion that is less than the maximum erosion and greater than half of the maximum erosion.

2. A sputtering method of producing semiconductor wafers comprising the steps of a method as claimed in Claim 1 and the steps of mounting a wafer (15) on the support and sputtering material from the target (10) onto the wafer (15).

3. A sputtering cathode assembly comprising a wafer support for holding a circular wafer (15) centered on an axis, a sputtering target (10) formed of sputtering material, having a circular outer rim centered on the axis, and a sputtering surface spaced from, parallel to and facing the support, a collimator (20,30,40) centered on the axis spaced from, between and parallel to the target (10) and the support, and having an aspect ratio of at least 0.5, the aspect ratio being the ratio of the thickness of the collimator (20,30,40) to the width of the cells of the collimator (20,30,40) and magnet assembly means positioned behind the target and configured for shaping a plasma adjacent the sputtering surface of the target (10) characterised in that the magnet assembly is configured for shaping the plasma to produce therewith an erosion profile on the sputtering surface of the target (10) that includes an annular peripheral area of maximum erosion adjacent the rim of the target (10) and an interior area radially inward of the peripheral area of generally uniform erosion that is less than the maximum erosion and greater than half of the maximum erosion.

4. A sputtering cathode assembly as claimed in Claim 3 wherein the collimator (20,30,40) has an aspect ratio of not less than 1.0 and not more than 2.0 and the magnet assembly means is configured to shape the plasma adjacent the sputtering surface of the target (10) to produce therewith an erosion profile on the sputtering surface in which the interior area has generally uniform erosion that is in the range between approximately 0.6 and 0.75 of the maximum erosion.

5. A sputtering cathode assembly as claimed in either Claim 3 or Claim 4 wherein the target (10) is approximately 50% larger than the wafer (15), the target (10) is spaced from the wafer (15) about 50% of the diameter of the wafer, and the collimator (20,30,40) is spaced from the wafer (15) about 3/16ths the diameter of the wafer.

6. A sputtering cathode assembly as claimed in any one of Claims 3 to 5 wherein the magnet assembly means is configured to shape the plasma to produce an erosion profile in the annular peripheral area that is generally gaussian in shape.

7. A sputtering cathode assembly as claimed in any one of Claims 3 to 6 wherein the magnet assembly means is configured to shape the plasma to produce an erosion profile in the annular peripheral area that is generally asymmetrical in a radial direction about a circle of maximum erosion.

8. A sputtering cathode assembly as claimed in any one of Claims 3 to 7 wherein the magnet assembly means is configured to shape the plasma to produce an erosion profile in the annular peripheral area that is approximately equal to **y(x)**, where **x** is the radius of the target and:

$$y(x) = I_0\, e^{-\left(\frac{x-x_0}{\sigma_1}\right)^2}$$

for $x \leq x_0$, and

$$y(x) = e^{-\left(\frac{x-x_0}{\sigma_2}\right)^2}$$

for $x \geq x_0$, where $x_0$ equals the radius to maximum erosion in the annular peripheral area , $\sigma_1$ and $\sigma_2$ equal the

---

distances from the maximum to half erosion points on the respective sides of the maximum.

9. A sputtering cathode assembly as claimed in Claim 8 wherein the magnet assembly means is configured to shape the plasma to produce an erosion profile in the interior area that is approximately equal to **y(x)** where **x** is the radius of the target and:

$$y(x) = \sum_{i=0}^{k} I_i \, e^{-\left(\frac{x-x_i}{\sigma_i}\right)^2}$$

where **m** and **n** equal, respectively, the minimum and maximum erosion intensity in the interior area, $I_i$ equals the amplitude of the peaks of a plurality of fluctuations **i** in the interior area, $I_i$ being less than < **(n-m)**, where the **x**, equal the approximate radii of the respective fluctuation peaks **i**, and $\sigma_i$ equal the distances from the respective peaks to half erosion points of the respective peaks.

10. A sputtering cathode assembly as claimed in any one of Claims 3 to 9 wherein the magnet assembly means includes at least one permanent magnet rotatable on the axis in a plane parallel to the wafer (15) opposite the target (10) therefrom, and configured to produce, when rotated, an erosion profile on the target (10) that is a function of the radius from the axis.

**Patentansprüche**

1. Sputter-Verfahren mit den Schritten der Bereitstellung eines Wafer-Trägers zum Halten eines kreisförmigen Wafers (15), der auf einer Achse zentriert ausgerichtet ist, Bereitstellen eines Sputter-Zieles (10), das aus einem Sputter-Material gebildet wird und welches einen kreisförmigen äußeren Rand hat, der bezüglich der Achse zentriert ausgerichtet ist, und welches eine davon beabstandete Sputter-Fläche hat, die parallel zu dem Träger angeordnet ist und diesem zugewandt ist, Bereitstellen eines Kollimators (20, 30, 40), der bezüglich der Achse zentriert angeordnet ist und der von dem Ziel (10) beabstandet und parallel zu diesem und zwischen diesem und dem Träger angeordnet ist und der ein Aspektverhältnis von zumindest 0,5 hat, wobei das Aspektverhältnis das Verhältnis der Dicke (T) des Kollimators (20, 30, 40) zur Breite der Zellen (21) des Kollimators ist, Formen eines Plasmas neben der Sputter-Oberfläche des Targets (10) mit Hilfe einer hinter dem Ziel (10) angeordneten Magnetaufbaueinrichtung, **dadurch gekennzeichnet**, daß das Plasma so geformt wird, daß ein Erosionsprofil auf der Sputter-Oberfläche des Zieles (10) erzeugt wird, welches einen ringförmig umlaufenden Bereich maximaler Erosion neben dem Rand des Zieles (10) erzeugt, sowie einen inneren Bereich, radial innerhalb des umlaufenden Bereiches, mit im wesentlichen gleichförmiger Erosion, die geringer ist als die maximale Erosion und die größer ist als die Hälfte der maximalen Erosion.

2. Sputter-Verfahren zum Herstellen von Halbeiter-Wafern mit den Schritten des Verfahrens nach Anspruch 1 und mit den weiteren Schritten, daß ein Wafer (15) auf dem Träger montiert wird und Material von dem Ziel (10) auf den Wafer (15) gesputtert wird.

3. Sputter-Kathodenaufbau mit einem Wafer-Träger zum Halten eines kreisförmigen Wafers (15), der bezüglich einer Achse zentriert ausgerichtet ist, einem Sputter-Ziel (10), das aus Sputter-Material gebildet ist und einen kreisförmigen äußeren Rand hat, der bezüglich der Achse zentriert ausgerichtet ist, und mit einer Sputter-Fläche, die von dem Träger beabstandet, dem Träger zugewandt und parallel zu diesem angeordnet ist. einem Kollimator (20, 30, 40), der bezüglich der Achse zentriert angeordnet ist und der von dem Ziel (10) beabstandet, parallel zu diesem und zwischen dem Ziel und dem Träger angeordnet ist und der ein Aspektverhältnis von zumindest 0,5 hat, wobei das Aspektverhältnis das Verhältnis der Dicke des Kollimators (20, 30, 40) zur Breite der Zellen des Kollimators (20, 30, 40) ist, und mit einer Magnetaufbaueinrichtung, die hinter dem Ziel angeordnet und so ausgestaltet ist, daß sie ein Plasma in der Nähe der Sputter-Oberfläche des Zieles (10) formt, **dadurch gekennzeichnet**, daß der Magnetaufbau derart ausgestaltet ist, daß er das Plasma so formt, daß damit ein Erosionsprofil auf der Sputter-Oberfläche des Zieles (10) gebildet wird, welches einen ringförmigen umlaufenden Bereich maximaler Erosion in der Nähe des Randes des Zieles (10) aufweist, sowie einen inneren Bereich radial innerhalb von dem umlaufenden Bereich und mit im wesentlichen gleichförmiger Erosion, die weniger als die maximale Erosion und mehr als die Hälfte der maximalen Erosion beträgt.

4. Sputter-Kathodenaufbau nach Anspruch 3, wobei der Kollimator (20, 30, 40) ein Aspektverhältnis von nicht weniger als 1,0 und nicht mehr als 2,0 hat und wobei die Magnetaufbaueinrichtung so ausgestaltet ist, daß sie das Plasma in der Nähe der Sputter-Fläche des Zieles (10) derart formt, daß dadurch ein Erosionsprofil auf der Sputter-Oberfläche erzeugt wird, bei welchem der innere Bereich eine in etwa gleichförmige Erosion hat, die im Bereich zwischen etwa 0,6 und 0,75 der maximalen Erosion liegt.

5. Sputter-Kathodenaufbau nach einem der Ansprüche 3 oder 4, wobei das Ziel (10) näherungsweise 50% größer ist als der Wafer (15), das Ziel (10) von dem Wafer (15) um etwa 50% des Durchmessers des Wafers beabstandet ist und der Kollimator (20, 30, 40) von dem Wafer (15) um etwa 3/16 des Durchmessers des Wafers beabstandet ist.

6. Sputter-Kathodenaufbau nach einem der Ansprüche 3 bis 5, wobei die Magnetaufbaueinrichtung derart ausgestaltet ist, daß sie das Plasma so formt, daß ein Erosionsprofil in dem ringförmig umlaufenden Bereich erzeugt wird, welches näherungsweise eine Gauss'sche Form hat.

7. Sputter-Kathodenaufbau nach einem der Ansprüche 3 bis 6, wobei die Magnetaufbaueinrichtung derart ausgestaltet ist, daß sie das Plasma so formt, daß ein Erosionsprofil in dem ringförmig umlaufenden Bereich erzeugt wird, welches in radialer Richtung um einen Kreis maximaler Erosion herum im wesentlichen asymmetrisch ist.

8. Sputter-Kathodenaufbau nach einem der Ansprüche 3 bis 7, wobei die Magnetaufbaueinrichtung so ausgestaltet ist, daß sie das Plasma derart formt, daß ein Erosionsprofil in dem ringförmig umlaufenden Bereich erzeugt wird, welches näherungsweise gleich y(x) ist, wobei x der Radius des Zieles ist und y(x) gleich

$$y(x) = I_0\, e^{-\left(\frac{x-x_0}{\sigma_1}\right)^2}$$

für $x \leq x_0$ und

$$y(x) = e^{-\left(\frac{x-x_0}{\sigma_2}\right)^2}$$

für $x \geq x_0$, wobei $x_0$ gleich dem Radius der maximalen Erosion in dem ringförmig umlaufenden Bereich ist, $\sigma_1$ und $\sigma_2$ die Abstände von diesem Maximum zu den Punkten halber Erosion auf den jeweiligen Seiten des Maximums sind.

9. Sputter-Kathodenaufbau nach Anspruch 8, wobei die Magnetaufbaueinrichtung so ausgestaltet ist, daß sie das Plasma derart formt, daß ein Erosionsprofil in dem inneren Bereich erzeugt wird, welches in etwa gleich y(x) ist, wobei x der Radius des Zieles ist und

$$y(x) = \sum_{i=0}^{k} I_i\, e^{-\left(\frac{x-x_i}{\sigma_i}\right)^2}$$

wobei m bzw. n der minimalen bzw. maximalen Erosionsintensität in dem inneren Bereich entsprechen, $I_i$ gleich der Amplitude der Spitzen einer Mehrzahl von Fluktuationen i in dem inneren Bereich sind, wobei $I_i < (n-m)$ ist, wobei $x_i$ näherungsweise gleich den Radien der jeweiligen Fluktuationspeaks i ist und $\sigma_i$ den Abständen der entsprechenden Peaks zu den Punkten halber Erosion der betreffenden Peaks ist.

10. Sputter-Kathodenaufbau nach einem der Ansprüche 3 bls 9, wobei die Magnetaufbaueinrichtung zumindest einen Permanentmagneten aufweist, der auf der Achse in einer Ebene, welche auf der gegenüberliegenden Seite des Zieles (10) liegt, parallel zu dem Wafer (15) drehbar ist, wobei der Magnet so ausgestaltet ist, daß er, wenn er gedreht wird, ein Erosionsprofil auf dem Ziel (10) erzeugt, das eine Funktion des von der Achse aus gemessenen Radius ist.

## EP 0 753 201 B1

**Revendications**

1.  Procédé de projection comprenant les étapes consistant à prévoir un support de pastille pour le maintien d'une pastille circulaire (15) centrée sur un axe, prévoir une cible de projection (10) formée de matériau de projection, possédant un bord externe circulaire centré sur l'axe et possédant une surface de projection espacée du support, parallèle et faisant face à celui-ci, prévoir un collimateur (20, 30, 40) centré sur l'axe et espacé de, entre et parallèle à la cible (10) et au support, et présentant un rapport de dimensions d'au moins 0,5, le rapport de dimensions étant le rapport de l'épaisseur (T) du collimateur (20, 30, 40) sur la largeur des cellules (21) du collimateur, conformer à l'aide d'un ensemble de moyens magnétiques positionné derrière la cible (10) un plasma adjacent à la surface de projection de la cible (10), caractérisé en ce que le plasma est conformé de façon à produire un profil d'érosion sur la surface de projection de la cible (10) comprenant une zone annulaire périphérique d'érosion maximale adjacente au bord de la cible (10) et une zone interne radialement à l'intérieur de la zone périphérique d'érosion globalement uniforme qui est inférieure à l'érosion maximale et supérieure à la moitié de l'érosion maximale.

2.  Procédé de projection pour la production de pastilles de semi-conducteur comprenant les étapes d'un procédé selon la revendication 1 et les étapes consistant à monter une pastille (15) sur le support et à projeter du matériau à partir de la cible (10) sur la pastille (15).

3.  Ensemble de cathode de projection comprenant un support de pastille pour le maintien d'une pastille circulaire (15) centrée sur un axe, une cible de projection (10) formée de matériau de projection, possédant un bord externe circulaire centré sur l'axe et une surface de projection espacée de, parallèle à et faisant face au support, un collimateur (20, 30, 40) centré sur l'axe et espacé de, entre et parallèle à la cible (10) et au support, et présentant un rapport de dimensions d'au moins 0,5, le rapport de dimensions étant le rapport de l'épaisseur du collimateur (20, 30, 40) sur la largeur des cellules du collimateur (20, 30, 40), un moyen d'ensemble magnétique positionné derrière la cible et configuré pour conformer un plasma adjacent à la surface de projection de la cible (10), caractérisé en ce que l'ensemble magnétique est configuré pour conformer le plasma afin de produire un profil d'érosion sur la surface de projection de la cible (10) comprenant une zone annulaire de périphérie d'érosion maximale adjacente au bord de la cible (10) et une zone interne radialement à l'intérieur de la zone de périphérie d'érosion globalement uniforme qui est inférieure à l'érosion maximale et supérieure à la moitié de l'érosion maximale.

4.  Ensemble de cathode de projection selon la revendication 3, dans lequel le collimateur (20, 30, 40) présente un rapport de dimensions non inférieur à 1,0 et ne dépassant pas 2,0 et le moyen d'ensemble magnétique est configuré pour conformer le plasma adjacent à la surface de projection de la cible (10) afin de produire en conséquence un profil d'érosion sur la surface de projection selon lequel la zone interne présente une érosion globalement uniforme comprise entre environ 0,6 et 0,75 fois l'érosion maximale.

5.  Ensemble de cathode de projection selon la revendication 3 ou 4, dans lequel la cible (10) est d'environ 50 % plus grande que la pastille (15), la cible (10) est espacée de la pastille (15) d'environ 50 % du diamètre de la pastille et le collimateur (20, 30, 40) est espacé de la pastille (15) d'environ 3/16 du diamètre de la pastille.

6.  Ensemble de cathode de projection selon l'une quelconque des revendications 3 à 5, dans lequel le moyen d'ensemble magnétique est configuré pour conformer le plasma afin de produire un profil d'érosion dans la zone annulaire de périphérie qui est de forme globale de Gauss.

7.  Ensemble de cathode de projection selon l'une quelconque des revendications 3 à 6, dans lequel le moyen d'ensemble magnétique est configuré pour conformer le plasma afin de produire un profil d'érosion dans la zone annulaire de périphérie qui est globalement asymétrique dans une direction radiale autour d'un cercle d'érosion maximale.

8.  Ensemble de cathode de projection selon l'une quelconque des revendications 3 à 7, dans lequel le moyen d'ensemble magnétique est configuré pour conformer le plasma afin de produire un profil d'érosion dans la zone annulaire de périphérie qui est à peu près égal à y(x) où x est le rayon de la cible et :

$$y(x) = I_0\, e^{-(\frac{x-x_0}{\sigma_1})^2}$$

pour $x \leq x_0$, et

$$y(x) = e^{-\left(\frac{x-x_0}{\sigma_2}\right)^2}$$

pour $x \geq x_0$

où $x_0$ est égal au rayon atteignant l'érosion maximale dans la zone annulaire de périphérie, $\sigma_1$ et $\sigma_2$ sont égaux aux distances des points d'érosion maximale aux points de demi-érosion sur les côtés respectifs du maximum.

9. Ensemble de cathode de projection selon la revendication 8, dans lequel le moyen d'ensemble magnétique est configuré pour conformer le plasma afin de produire un profil d'érosion dans la zone interne qui est à peu près égal à y(x) où x est le rayon de la cible et :

$$y(x) = \sum_{i=0}^{k} I_i \, e^{-\left(\frac{x-x_i}{\sigma_i}\right)^2}$$

où m et n sont respectivement égaux à l'intensité d'érosion minimale et maximale dans la zone interne, $I_i$ est égal à l'amplitude des pics d'une pluralité de fluctuations i dans la zone interne, $I_i$ étant inférieur à $(n - m)$, $x_i$ est égal aux rayons approximatifs des pics respectifs de fluctuation i et $\sigma_i$ est égal aux distances des pics respectifs aux points de demi-érosion des pics respectifs.

10. Ensemble de cathode de projection selon l'une quelconque des revendications 3 à 9, dans lequel le moyen d'ensemble magnétique comprend au moins un aimant permanent pouvant tourner sur l'axe dans un plan parallèle à la pastille (15) opposée à la cible (10), et configuré pour produire, lors d'une rotation, un profil d'érosion sur la cible (10) qui est fonction du rayon à partir de l'axe.

FIG. I

FIG. 2

FIG. 3

FIG. 4

FIG. 5

FIG. 6

COLLIMATOR
WAFER DISTANCE=2"
CELL DIA.=0.435"
ASPECT RATIO

FIG. 7

COLLIMATOR
CELL DIA.=0.435"
ASPECT RATIO

FIG. 8

15